# EUROPÄISCHE PATENTSCHRIFT

(11) **EP 1 403 135 B1**
(45) Veröffentlichungstag und Bekanntmachung des Hinweises auf die Patenterteilung: **28.02.2007**
(21) Anmeldenummer: 03021290.6
(22) Anmeldetag: 19.09.2003
(51) Int. Cl.: B60Q 1/04, B60Q 1/14, F21S 8/12, F21S 8/10

(54) **Beleuchtungseinrichtung insbesondere für ein Kraftfahrzeug**
Lighting device in particular for a vehicle
Dispositif d'éclairage notamment pour un véhicule

(30) Priorität: 27.09.2002 DE 10245296
(43) Veröffentlichungstag der Anmeldung: 31.03.2004
(73) Patentinhaber: AUDI AG, 85045 Ingolstadt (DE)
(72) Erfinder: Huhn, Wolfgang, Dr., 85084 Reichertshofen (DE); Berlitz, Stephan, 86529 Schrobenhausen (DE)
(74) Vertreter: Thielmann, Frank

(56) Entgegenhaltungen:
- DE-A1- 10 009 782
- DE-A1- 10 009 783
- DE-A1- 10 129 743

## Beschreibung

Die Erfindung betrifft eine Beleuchtungseinrichtung insbesondere für ein Kraftfahrzeug, umfassend mehrere Leuchteinheiten umfassend wenigstens eine lichtemittierende Diode (LED) sowie eine der Diode zugeordnete, das emittierte Licht fokussierende Optik, in deren Brennpunkt die Diode angeordnet ist.

Vornehmlich auf dem Kraftfahrzeugsektor geht die aktuelle Entwicklung dahin, die üblichen Scheinwerfer mit Halogenleuchten durch sogenannte LED-Scheinwerfer zu ersetzen. Solche LED-Scheinwerfer umfassen mehrere Leuchteinheiten, von denen jede wenigstens eine lichtemittierende Diode (LED) aufweist. Jede Diode emittiert Licht, das über die zugeordnete Optik fokussiert und über einen Reflektor reflektiert und abgestrahlt wird. Nachdem mehrere solcher Leuchteinheiten über die Scheinwerferfläche verteilt angeordnet sind, sind über die Scheinwerferfläche entsprechend viele einzelne Leuchtpunkte gegeben, die bei entsprechender Ausbildung des Reflektors und Einstellung der Leuchteinheiten eine zonenweise Ausleuchtung des Bereichs vor dem Fahrzeug ermöglicht. Die einzelnen Leuchteinheiten sind dabei so eingestellt bzw. der Reflektor so ausgebildet, dass sie die einzelnen Zonen quasi additiv zu einer gesamten Ausleuchtfläche addieren.

Gleichwohl sind auch bei diesem neuartigen Scheinwerfertyp Vorschriften hinsichtlich der Beleuchtung gegeben, insbesondere betreffend die Hell-Dunkel-Grenze. Die Hell-Dunkel-Grenze gibt den Übergangsbereich an, wo der erhellte Ausleuchtbereicht in den dunklen, nicht ausgeleuchteten Bereich, der oberhalb davon liegt, übergeht. Diese Hell-Dunkel-Grenze ist konstruktiv vorgegeben, dadurch starr und im Betrieb bei bekannten LED-Scheinwerfern nicht veränderbar. Je nach Witterung oder Umgebung oder Fahrsituation wäre eine harte oder weiche Hell-Dunkel-Grenze angenehmer bzw. sicherer für den Fahrer und den Gegenverkehr. Die Begriffe "hart" oder "weich" geben dabei die Art bzw. Qualität des Übergangs Hell-Dunkel an dieser Grenze an, ob dieser also sehr scharf oder weniger scharf aufgeweicht ist. Auf diese Situationen kann aber nicht eingegangen werden, da die Hell-Dunkel-Grenze, wie beschrieben, konstruktiv starr ist.

Dokument DE 100 09 783 A1 offenbart eine Beleuchtungseinrichtung für Kraftfahrzeuge mit mehreren Leuchteinheiten, die jeweils drei Leuchtdioden die unterschiedliche Farben enthalten. Die drei Leuchtdioden erzeugen durch deren Mischung weißes Licht.

Der Erfindung liegt das Problem zu Grunde, eine Möglichkeit einer variablen Aufweichung der Hell-Dunkel-Grenze bei LED-Beleuchtungseinrichtungen wie Kraftfahrzeugscheinwerfern anzugeben.

Zur Lösung dieses Problems ist bei einer Beleuchtungseinrichtung der eingangs genannten Art erfindungsgemäß vorgesehen, dass zumindest ein Teil der Leuchteinheiten wenigstens eine zweite lichtemittierende Diode aufweist, die außerhalb des Brennpunkts der gemeinsamen Optik angeordnet ist.

Eine Optikabbildung basiert auf Abbildungen eines Brennpunkts. Liegt eine Lichtquelle außerhalb des Brennpunkts, ist sie also defokussiert angeordnet, wird die Abbildung unschärfer. Diesen Effekt nutzt man bei der erfindungsgemäßen Beleuchtungseinrichtung vorteilhaft aus. Bei der erfindungsgemäßen Beleuchtungseinrichtung sind zumindest bei einem Teil der Leuchteinheiten weitere zweite Dioden defokussiert angeordnet. Es ergibt sich also eine defokussierte Lichtemission, wenn diese zweiten Dioden betrieben werden. Es wird ein defokussierter Anteil am Gesamtlicht erzeugt. Durch diesen defokussierten Anteil kann somit auf einfache Weise die Hell-Dunkel-Grenze aufgeweicht werden, es ergibt sich also ein weicherer Hell-Dunkel-Übergang. Dies setzt natürlich voraus, dass die Leuchteinheiten, die den Grenzbereich ausleuchten, erfindungsgemäß ausgestaltet sind und die wenigstens eine zweite defokussiert angeordnete Diode aufweisen.

Je nach Platzierung der Leuchteinheiten mit den weiteren Dioden kann natürlich auch die Lichtverteilung im restlichen ausgeleuchteten Bereich (Vorfeld, seitlicher Bereich etc.) variiert werden. Denn auf Grund der Tatsache, dass mehr Lichtquellen zur Verfügung stehen, kann die Gesamthelligkeit auf Grund der Intensitätserhöhung bedingt durch den Betrieb dieser defokussierten LEDs bei weicheren Übergängen im Vorfeld, Seitenbereich oder im Asymmetriezwickel erhöht werden.

Die Lichtverteilung kann auch vorteilhaft ohne mechanische Zusatzbauteile zur Erzielung einer mechanisch induzierten Defokussierung in den Übergängen der Ausleuchtbereiche verändert werden. Zusätzlich kann die Helligkeit erhöht werden, ohne dass die Übergänge dadurch stärker betont werden. In Fahrsituationen bei Nebel, Regen, Schnee, Gischt etc. ist eine scharfe Hell-Dunkel-Grenze anzustreben. Bei klarer Sicht jedoch, auf Autobahnen mit viel Hineinleuchten in die Spiegel der Vorausfahrenden, ist eine weichere Hell-Dunkel-Grenze für den Fahrer und die anderen Verkehrsteilnehmer angenehmer, die mit der erfindungsgemäßen Beleuchtungseinrichtung ohne Weiteres realisiert werden kann. Diese Aufweichung kann partiell nur für die Asymmetriezone erfolgen, der Bereich für den Gegenverkehr bleibt möglichst scharf und damit blendfreier.

Wenngleich in einer einfachsten Ausführungsform eine Leuchteinheit nur eine weitere defokussiert angeordnete zweite Diode aufweisen kann, ist es zweckmäßig, wenn eine Leuchteinheit mehrere verteilt und außerhalb des Brennpunkts der gemeinsamen Optik angeordnete zweite Diode aufweist. Dabei können die oder alle zweiten Dioden und die erste Diode im Wesentlichen in der gleichen Ebene angeordnet sein, d. h. sie liegen alle nebeneinander. Daneben ist es aber auch denkbar, dass die oder alle zweiten Dioden und die erste Diode in unterschiedlichen Ebenen bezüglich der Lichtemissionsrichtung angeordnet sind. Dies ist eine Frage der Auslegung einer Leuchteinheit bzw. einer LED, d. h. wo an ihr letztlich das emittierte Licht ausgekoppelt wird.

Besonders vorteilhaft ist es, wenn die erste oder die oder alle zweiten Dioden separat ansteuerbar sind, d. h. es besteht die Möglichkeit, die oder alle zweiten Dioden wahlweise zu- oder abzuschalten. Ein übergeordnetes Steuergerät kann also beispielsweise bei Erfassen einer entsprechenden Fahrsituation selbständig die oder alle zweiten Dioden, gegebenenfalls auch partiell in bestimmten Bereichen über die Scheinwerferfläche zu- oder abschalten, um so optimiert auf die Fahrsituation reagieren zu können. Daneben ist es in Weiterbildung des Erfindungsgedankens zweckmäßig, wenn bei mehreren zweiten Dioden jede Diode allein ansteuerbar ist, auch eine gruppenweise Ansteuerung der Dioden ist denkbar. D. h. hierbei sind die einzelnen einer ersten Diode zugeordneten zweiten Dioden separat ansteuerbar. Hierdurch kann also quasi der Grad der Aufweichung durch wahlweises Zuschalten einer, zweiter, dreier, etc. zweiter Dioden einer Leuchteinheit variiert werden, entsprechendes gilt für die Intensitätserhöhung innerhalb einer Leuchteneinheit und damit auch die Intensitätserhöhung der Gesamthelligkeit. Hier sind sämtliche möglichen Einzel- oder Gruppensteuermöglichkeiten denkbar.

Wie beschrieben, ist zur Steuerung aller Leuchteinheiten und mithin auch der einzelnen zweiten Dioden (-gruppen) eine zentrale Steuerungseinrichtung vorgesehen. Dieser Steuerungseinrichtung können wie bereits beschrieben irgendwelche Sensoren zur Erfassung etwaiger fahrsituationsspezifischer Randbedingungen zugeordnet sein, in Abhängigkeit welcher dann, beispielsweise automatisch, entsprechende Einstellungen der Beleuchtungseinrichtung vorgenommen werden, oder aber dem Fahrer entsprechende Informationen gegeben werden, wie er aktiv die Beleuchtung zur Optimierung ändern sollte etc..

Wie beschrieben, kann die Lichtintensität durch gesteuertes Zuschalten einer entsprechenden Anzahl weiterer zweiten Dioden erhöht oder erniedrigt werden. Um eine weitere Veränderungsmöglichkeit zu realisieren, kann erfindungsgemäß die Intensität des emittierten Lichts der oder aller zweiten Dioden variabel steuerbar sein. D. h. eine solche Diode kann nicht nur an- und ausgeschalten werden, vielmehr kann die Intensität des emittierten Lichts durch entsprechende Steuerung der Bestromung einer zweiten LED variiert werden. Insgesamt lässt sich also, vor allem dann, wenn jede zweite Diode einzeln ansteuerbar ist, eine beliebige Intensitätsveränderung erzielen, wobei diese noch mal beliebig bereichsweise über die Scheinwerferfläche variiert werden kann.

Hinsichtlich der Ausgestaltung einer Leuchteinheit sind verschiedene Ausführungsformen denkbar. Eine erste sieht vor, die erste und die oder alle zweiten Dioden einer Leuchteinheit in einer transparente, die Optik bildende Masse einzugießen, vorzugsweise ein Epoxy-Harz. Alternativ dazu besteht die Möglichkeit, die Optik einer Leuchteinheit als separates, von den Dioden beabstandetes Element auszuführen, das also der Leuchteinheit unmittelbar vorgeschaltet ist.

Neben der erfindungsgemäßen Beleuchtungseinrichtung betrifft die Erfindung ferner ein Kraftfahrzeug, das sich dadurch auszeichnet, dass es zwei als Frontscheinwerfer ausgebildete Beleuchtungseinheiten der beschriebenen Art aufweist. Zur Steuerung der Leuchteinheiten beider Beleuchtungseinrichtungen ist beim erfindungsgemäßen Kraftfahrzeug zweckmäßiger Weise eine gemeinsame Steuerungseinrichtung vorgesehen.

Weitere Vorteile, Merkmale und Einzelheiten der Erfindung ergeben sich aus den im Nachfolgenden beschriebenen Ausführungsbeispielen sowie an Hand der Zeichnungen. Dabei zeigen:
- Fig. 1: eine Prinzipskizze der Funktionsweise einer Leuchteinheit,
- Fig. 2: eine Prinzipskizze zur Lichtverteilung und Zonenausleuchtung unter Verwendung mehrerer Leuchteinheiten,
- Fig. 3: eine Darstellung der Lichtverteilung an der 25m-Wand zur Darstellung der Hell-Dunkel-Grenze,
- Fig. 4: eine Schnittansicht einer erfindungsgemäßen Leuchteinheit einer ersten Ausführungsform,
- Fig. 5: eine Schnittansicht einer erfindungsgemäßen Leuchteinheit einer zweiten Ausführungsform,
- Fig. 6: eine Prinzipdarstellung betreffend die Ansteuerung einzelner LEDs,
- Fig. 7: eine prinzipielle Schaltungsanordnung zur separaten LED-Ansteuerung,
- Fig. 8: eine dritte Ausführungsform einer erfindungsgemäßen Leuchteinheit,
- Fig. 9: eine Prinzipskizze eines erfindungsgemäßen Scheinwerfers eines Kraftfahrzeugs als Prinzipdarstellung
- Fig. 10: eine Prinzipdarstellung der Ausleuchtung unter Verwendung einer erfindungsgemäßen Beleuchtungseinrichtung bei einem Kraftfahrzeug am Beispiel einer Stadtlichtverteilung ohne Aufweichung der Hell-Dunkel-Grenze,
- Fig. 11: die Prinzipdarstellung aus Fig. 10 mit Aufweichung der Hell-Dunkel-Grenze sowie der Übergänge,
- Fig. 12: eine Darstellung entsprechend Fig. 10 jedoch betreffend eine Landstraßenausleuchtung ohne Aufweichung und
- Fig. 13: die Ausleuchtung nach Fig. 12 mit Aufweichung der Hell-Dunkel-Grenze bzw. der Übergänge.

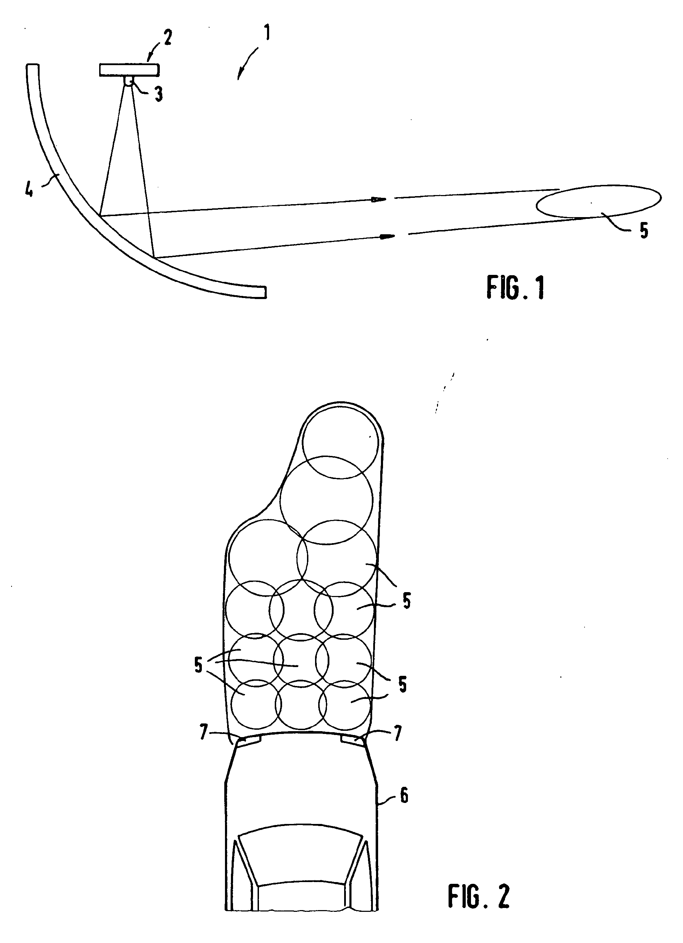

Fig.1 zeigt in Form einer Prinzipskizze die optische Darstellung einer erfindungsgemäßen Beleuchtungseinrichtung, hier am Beispiel eines Scheinwerfers eines Kraftfahrzeugs. Gezeigt ist eine Beleuchtungseinrichtung 1 umfassend im gezeigten Beispiel eine Leuchteinheit 2, die zu Darstellungszwecken lediglich eine lichtimitierende Diode 3 nebst zugeordneter, nicht näher gezeigter Optik umfasst. Über die Optik, in deren Brennpunkt die Diode 3 sitzt, wird das von der Diode emittierte Licht auf einen Reflektor 4 fokussiert, der das Licht aus dem Scheinwerfer heraus reflektiert. Das reflektierte Licht trifft im gezeigten Beispiel auf eine Straße und beleuchtet dort eine abgegrenzte Zone 5.

Eine erfindungsgemäße Beleuchtungseinrichtung bzw. ein Scheinwerfer für ein Kraftfahrzeug umfasst eine Vielzahl einzelner Leuchteinheiten 2. Diese leuchten in ihrer Gesamtheit die Straße aus, wie in Fig. 2 gezeigt. Dort ist ein erfindungsgemäßes Kraftfahrzeug 6 mit zwei Frontscheinwerfern 7 gezeigt, die gemäß der Erfindung ausgebildet sind. Jeder Frontscheinwerfer 7 umfasst eine Mehrzahl an separater Leuchteinheiten, über die unterschiedliche Zonen 5 auf der Straße ausgeleuchtet werden. Insgesamt ergibt sich eine Lichtverteilung, wie durch die äußere Linie dargestellt ist.

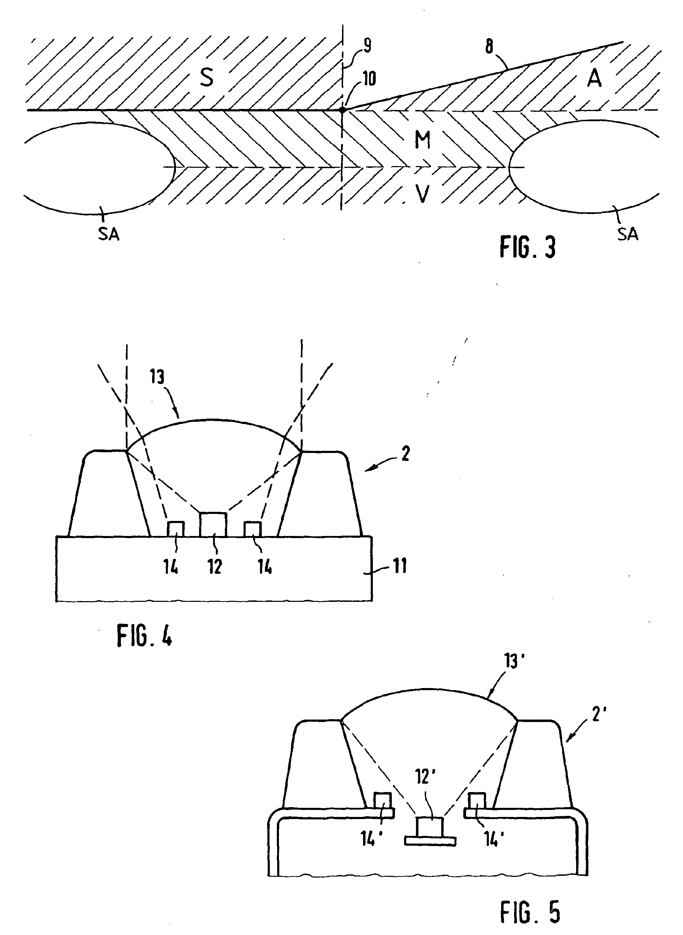

Die Lichtverteilung dieser in Fig. 2 gezeigten Zonenausleuchtung an der 25 m-Wand ist in Fig. 3 dargestellt. Gezeigt ist die Hell-Dunkel-Grenze 8, unterhalb welcher der Vorfeldbereich V, der Mittelbereich M und die Asymmetriezone A zu unterscheiden sind. Oberhalb der Hell-Dunkel-Grenze 8 befindet sich der nicht ausgeleuchtete Streulichtbereich S. Im Bereich der optischen Achse 9 beschreibt die Hell-Dunkel-Grenze 8 einen Knick, den sogenannten Asymmetriezwickel 10, an den sich die Asymmetriezone A anschließt. Weiterhin sind die beiden Bereiche der Seitenausleuchtung SA dargestellt.

Ziel der Erfindung ist es nun, die Hell-Dunkel-Grenze aufweichen zu können, also den Bereich des Übergangs von den hell ausgeleuchteten Bereichen (Vorfeldbereich, Mittelbereich, Asymmetriezone) zum dunklen Bereich (der allerhöchstens durch das Streulicht ausgeleuchtet wird) möglichst weich und angenehm zu gestalten. Darüber hinaus ist es Ziel, die einzelnen Zonenübergänge, wo also eine Zone 5 in ein nächstes übergeht, weich und fließend zu gestalten.

Hierzu ist eine erfindungsgemäße Beleuchtungseinrichtung, also z.B. ein Kfz-Frontscheinwerfer, unter Verwendung beispielsweise mehrerer einzelner Leuchteinheiten 2, wie in Fig. 4 dargestellt, aufgebaut. Eine solche Leuchteinheit 2 besteht im gezeigten Beispiel aus einem Träger 11, auf dem eine erste LED 12 angeordnet ist. Dieser ersten LED ist eine Optik 13 vorgeschaltet, die im gezeigten Beispiel unter Verwendung eines Epoxy-Harzes gebildet ist. D.h. die Diode 12 ist vollständig in dieses Material eingegossen, oberseitig ist die linsenförmige Struktur ausgebildet. Die Diode 12 sitzt im Brennpunkt der Optik 13, ihr emittiertes Licht wird über die Optik 13 entsprechend fokussiert ausgekoppelt.

Neben der ersten Diode 12 sind im gezeigten Beispiel zwei weitere zweite Dioden 14 vorgesehen, die jedoch nicht im Brennpunkt sondern daneben, also defokussiert bezüglich der ersten Diode 12 liegen. Nachdem ihr Licht defokussiert erzeugt wird, wird es auch defokussiert aus der Optik 13 ausgekoppelt, es wird also nicht wie das Licht der ersten Diode 12 scharf abgebildet, sondern unscharf und verschwommen. Hierdurch ist es möglich, zum einen jede Zone 5 randseitig unscharf abzubilden, zum anderen gilt dies natürlich auch im Bereich der Hell-Dunkel-Grenze 8 aus Fig. 3. Sind alle Leuchteinheiten eines erfindungsgemäßen Scheinwerfers gemäß Fig. 4 aufgebaut, so bietet sich zum einen die Möglichkeit, die Hell-Dunkel-Grenze 8 entsprechend aufzuweichen, da natürlich auch an diesem Übergang entsprechend unscharfe Lichtverteilungen gegeben sind. Zum anderen kann der gesamte Ausleuchtungsbereich, also auch der Übergang einzelner Zonen, entsprechend homogenisiert und weich gemacht werden.

Eine weitere Ausführungsform zeigt Fig. 5. Die dort gezeigte Leuchteinheit 2' zeigt ebenfalls eine erste Diode 12' mit zugeordneter Optik 13', ferner sind zwei defokussiert angeordnete zweite Dioden 14' vorgesehen. Während in der Ausführungsform in Fig. 4 die Dioden 12 und 14 in einer Ebene angeordnet sind, sind hier die Dioden gestaffelt angeordnet, die erste Diode 12' liegt bezogen auf die Lichtemissionsrichtung hinter den zweiten Dioden 14'. Gleichwohl gilt auch hier das Grundprinzip, nämlich dass die erste Diode 12' im Brennpunkt der Optik 13' liegt, während die zweiten Dioden 14' außerhalb des Brennpunkts angeordnet sind.

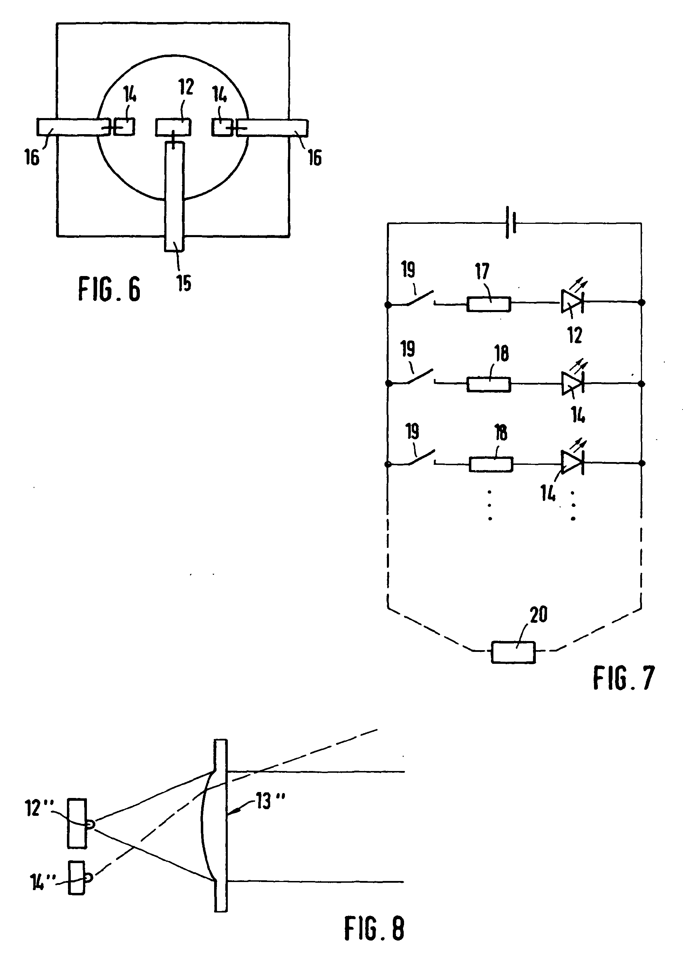

Zweckmäßig ist es, wenn alle Dioden separat angesteuert werden können. Fig. 6 zeigt in einer Prinzipskizze die Möglichkeit, die zentrale erste Diode 12 über eine erste Ansteuerungsleitung 15 separat anzusteuern, entsprechend sind auch die zweiten Dioden 14 jeweils über separate Ansteuerleitungen 16 ansteuerbar. D.h. je nach Belieben kann nur die erste Diode 12 angesteuert und mithin nur das "Grundlicht" erzeugt werden, wahlweise kann bei Bedarf zusätzlich die eine oder beide der weiteren Dioden 14 angesteuert und das "defokussierte Zusatzlicht" erzeugt werden. Hierüber kann natürlich auch die Gesamtintensität des von einer Leuchteinheit 2 abgegebenen Lichts und dadurch die Gesamthelligkeit der Ausleuchtung entsprechend variiert werden.

Fig. 7 zeigt in Form einer Prinzipskizze eine Schaltungsanordnung. Gezeigt ist die erste Diode 12 sowie die beiden weiteren zweiten Dioden 14. Jeder dieser Dioden ist ein Vorwiderstand 17 (zur Diode 12) bzw. 18 (zu den Dioden 14) vorgeschalten. Über elektronische Schalter 19 können nun beliebig die einzelnen Dioden über eine zentrale Steuerungseinrichtung 20 zugeschalten werden. Diese zentrale Steuerungseinrichtung 20 dient zum Steuern beider Beleuchtungseinrichtungen eines Kraftfahrzeugs. Über sie können beliebig die ersten und zweiten Dioden angesteuert werden, so dass sich quasi beliebige Diodenbetriebsmuster über die Matrix der Leuchteinheiten, die die beiden Frontscheinwerfer bilden, ansteuern lassen. Es können die zweiten Dioden nur einige ausgewählter Leuchteinheiten zusätzlich angesteuert werden, es können bereichsweise die Leuchteinheiten betrieben werden bzw. deren zweite Dioden angesteuert werden, so dass sich bereichsweise Helligkeits- oder Intensitätsunterschiede erzielen lassen, etc. Daneben besteht die Möglichkeit, durch gegebenenfalls erforderliche Änderungen der Schaltungsanordnung die Intensität des emittierten Lichts einer zweiten Diode 14 (oder auch einer ersten Diode 12) entsprechend zu variieren etc. Die separate Ansteuerbarkeit bietet damit die Möglichkeit, die Ausleuchtung sowohl hinsichtlich der Hell-Dunkel-Übergänge wie auch der Intensität- bzw. Helligkeitsverteilung beliebig steuern zu können. Diese prinzipielle Schaltungsanordnung kann für alle beschriebenen Ausführungsformen verwendet werden.

Fig. 8 zeigt eine weitere erfindungsgemäße Ausführungsform einer Leuchteinheit 2". Auch hier ist eine erste LED 12" und eine zweite Diode 14" vorgesehen. Beiden gemeinsam ist wiederum eine Optik 13" gemeinsam zugeordnet, wobei auch hier die erste Diode 12" im Brennpunkt der Optik 13" angeordnet ist. Die zweite Diode 14" ist außerhalb des Brennpunkts angeordnet. Anders als bei den Ausführungsformen gemäß den Figuren 4 und 5, wo die Dioden 12, 14 bzw. 12', 14' in die die Optik bildende transparente Epoxy-Masse eingegossen sind, ist hier die Optik 13" ein separates Bauteil, das den beiden Dioden 12" und 14" zugeordnet ist. Auch hier gilt das gleiche Funktionsprinzip bezüglich der Ausleuchtung und Ansteuerung, wie bezüglich der anderen Ausführungsformen beschrieben.

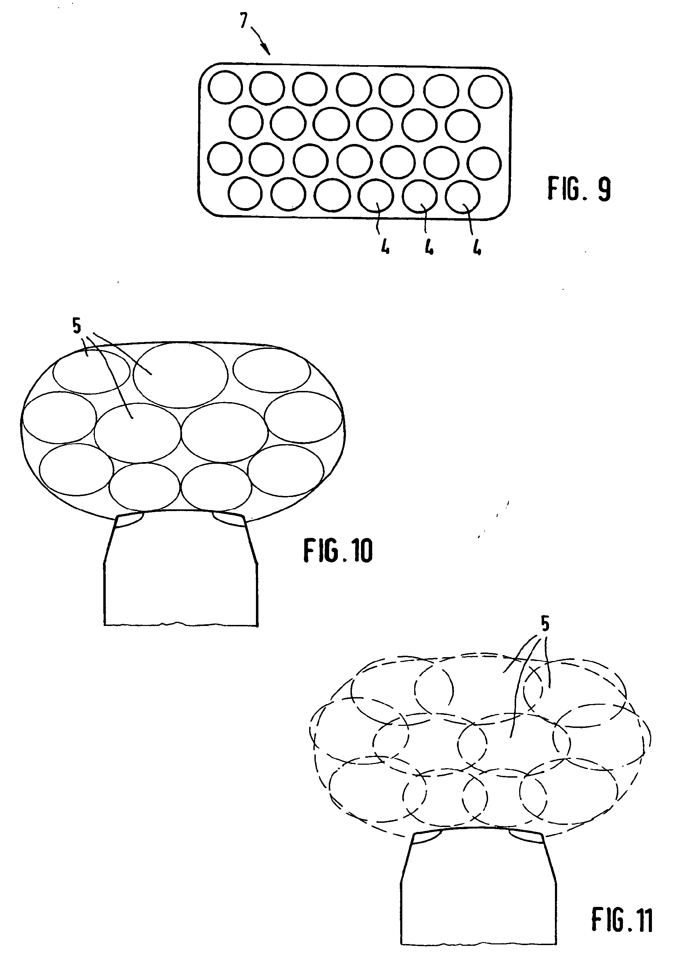

Fig. 9 zeigt nun in Form einer Prinzipskizze eine erfindungsgemäße Beleuchtungseinrichtung 7 in einer Aufsicht. Gezeigt sind die einzelnen Reflektoren 4, wobei jedem Reflektor eine hier nicht näher gezeigte Leuchteinheit der erfindungsgemäßen Art wie in den Figuren 4, 5 und 8 beschrieben (also mit integrierter oder separater Optik) zugeordnet ist. Ersichtlich wird eine Beleuchtungseinrichtung über eine Matrix an einzelnen Reflektoren und damit Leuchteinheiten gebildet. Nachdem die Leuchteinheiten separat angesteuert werden können, lassen sich wie beschrieben unterschiedliche Lichtverteilungen erzeugen.

Fig. 10 zeigt in Form einer Prinzipskizze eine "Stadtlichtverteilung", also eine Lichtverteilung, wie sie bei einer Stadtfahrt bevorzugt wird. Ersichtlich ist die Lichtverteilung sehr breit, die Ausleuchtung erfolgt primär im Vorfeld und nicht allzu weit nach vorne, dafür jedoch verstärkt zur Seite. Die einzelnen Zonen 5 sind relativ scharf voneinander abgegrenzt, d.h. hier ist der Fall dargestellt, dass nur die ersten Dioden angesteuert werden, nicht aber die zweiten quasi aufweichend wirkenden Dioden. Auch werden nicht alle Leuchteinheiten betrieben, sondern nur die, die für diese dargestellte Lichtverteilung erforderlich sind.

Fig. 11 zeigt nun als Prinzipskizze, wie sich die Lichtverteilung bei Hinzuschalten beispielsweise aller weiterer zweiter Dioden der bereits betriebenen Leuchteinheiten ändert. Ersichtlich bleibt es primär bei der generellen breiten, sich wenig nach vorne erstreckenden Lichtverteilung. Jedoch ergeben sich insgesamt, wie durch die gestrichelte Darstellung der etwas größeren Zonen 5 angedeutet ist, weichere Übergänge, sowohl von Zone zu Zone als auch an der Hell-Dunkel-Grenze. Daneben besteht natürlich die Möglichkeit, bei Schlechtwetter oder bei schlechter Sicht zusätzliche Helligkeiten dazu zu schalten, entweder indem beispielsweise noch zusätzliche zweite Dioden zugeschaltet werden, sofern bei den betriebenen Leuchteinheiten noch zuschaltbare zweite Dioden vorhanden sind, oder durch Änderung der Ansteuerung der zweiten Dioden derart, dass die Intensität des emittierten Lichts erhöht wird. Natürlich ist es auch denkbar, noch weitere Leuchteinheiten generell hinzuzuschalten.

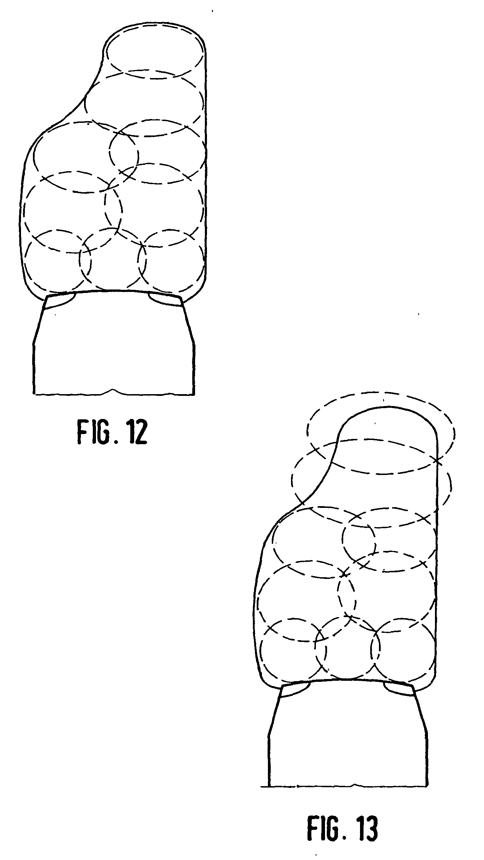

Die Fig. 12 zeigt die Lichtverteilung, wenn auf Landstraßen gefahren wird. Ersichtlich ergibt sich hier eine etwas schmälere Lichtverteilung, jedoch wird deutlich weiter nach vorne ausgeleuchtet. Hier werden also andere Leuchteinheiten betrieben als bei der in den Figuren 10 und 11 gezeigten "Stadtlichtverteilung". Dies kann auf einfache Weise durch entsprechende Änderung der Ansteuerung der benötigten Leuchteinheiten erfolgen. Auch hier ist der Fall dargestellt, dass die oder alle zweiten Dioden der betriebenen Leuchteinheiten ebenfalls betrieben werden, so dass sich der insgesamt weiche Übergang von Zone zu Zone sowie im Bereich der Hell-Dunkel-Grenze wie auch eine insgesamt homogene Lichtverteilung ergibt.

Fig. 13 zeigt schließlich abschließend die Lichtverteilung bei einer Autobahnfahrt. Hier kann durch entsprechende Aufweitung der Hell-Dunkel-Grenze durch entsprechendes Ansteuern weiterer zweiter Dioden sowie durch entsprechende Wahl der Intensität des von ihn emittierten Lichts mehr Reichweite erzielt werden, so dass die Sicht insgesamt besser wird.

## Patentansprüche

1. Beleuchtungseinrichtung (1) insbesondere für ein Kraftfahrzeug, umfassend mehrere Leuchteinheiten (2, 2', 2") umfassend jeweils wenigstens eine lichtemittierende Diode (LED) (12, 12', 12") sowie eine der Diode zugeordnete, das emittierte Licht fokussierende Optik, (13, 13', 13") in deren Brennpunkt die Diode (12, 12', 12") angeordnet ist,
**dadurch gekennzeichnet,**
**dass** zumindest ein Teil der Leuchteinheiten (2, 2', 2") wenigstens eine zweite lichtemittierende Diode (14, 14', 14") aufweist, die außerhalb des Brennpunkts der gemeinsamen Optik (13, 13', 13") angeordnet ist, wobei die erste Diode (12, 12', 12") und die oder alle zweiten Dioden (14, 14', 14") separat ansteuerbar sind.

2. Beleuchtungseinrichtung nach Anspruch 1,
**dadurch gekennzeichnet,**
**dass** eine Leuchteinheit (2, 2', 2") mehrere verteilt und außerhalb des Brennpunkts der gemeinsamen Optik (13, 13', 13") angeordnete zweite Dioden (14, 14', 14") aufweist.

3. Beleuchtungseinrichtung nach Anspruch 1 oder 2,
**dadurch gekennzeichnet,**
**dass** die oder alle zweiten Dioden (14, 14") und die erste Diode (12, 12") im Wesentlichen in der gleichen Ebene angeordnet sind.

4. Beleuchtungseinrichtung nach Anspruch 1 oder 2,
**dadurch gekennzeichnet,**
**dass** die oder alle zweiten Dioden (14') und die ersten Diode (12') in unterschiedlichen Ebenen bezüglich der Lichtemissionsrichtung angeordnet sind.

5. Beleuchtungseinrichtung nach einem der vorangehenden Ansprüche,
**dadurch gekennzeichnet,**
**dass** bei mehreren zweiten Dioden (14, 14', 14") jede Diode einzeln ansteuerbar ist, oder dass die Dioden gruppenweise ansteuerbar sind.

6. Beleuchtungseinrichtung nach einem der vorangehenden Ansprüche,
**dadurch gekennzeichnet,**
**dass** eine zentrale Steuerungseinrichtung (20) zur Ansteuerung aller Leuchteinheiten (2, 2', 2") einer Beleuchtungseinrichtung (7) vorgesehen ist.

7. Beleuchtungseinrichtung nach einem der vorangehenden Ansprüche,
**dadurch gekennzeichnet,**
**dass** die Intensität des emittierten Lichts der oder aller zweiten Dioden (14, 14', 14") variabel steuerbar ist.

8. Beleuchtungseinrichtung nach einem der vorangehenden Ansprüche,
**dadurch gekennzeichnet,**
**dass** die erste (12, 12') und die oder alle zweiten Dioden (14, 14') einer Leuchteinheit (2, 2') in eine transparente, die Optik (13, 13') bildende Masse eingegossen sind.

9. Beleuchtungseinrichtung nach einem der Ansprüche 1 bis 5,
**dadurch gekennzeichnet,**
**dass** die Optik (13") einer Leuchteinheit (2") ein separates, von den Dioden (12", 14") beabstandetes Element ist.

## Claims

1. Lighting device (1) in particular for a vehicle, comprising several light units (2, 2', 2"), each comprising at least one light emitting diode (LED) 12, 12', 12") and optics (13, 13' 13") allocated to the diode, focussing the light emitted, at the focal point of which the diode (12, 12', 12") is arranged,
**characterised in that**
at least one part of the light units (2, 2', 2") has at least a second light emitting diode (14, 14', 14"), which is arranged outside the focal point of the common optics (13, 13', 13"), in which the first diode (12, 12', 12") and the or all the second diodes (14, 14', 14") can be controlled separately.

2. Lighting device according to claim 1,
**characterised in that**
a light unit (2, 2', 2") has several second diodes (14, 14', 14") distributed and arranged outside the focal point of the common optics (13, 13', 13").

3. Lighting device according to claim 1 or 2,
**characterised in that**
the or all the second diodes (14, 14") and the first diode (12, 12") are arranged essentially in the same plane.

4. Lighting device according to claim 1 or 2,
**characterised in that**
the or all the second diodes (14') and the first diode (12') are arranged on various planes with reference to the direction of emission of the light.

5. Lighting device according to one of the previous claims,
**characterised in that**
in the case of several second diodes (14, 14', 14") every diode can be controlled individually or the diodes can be controlled in groups.

6. Lighting device according to one of the previous claims,
**characterised in that**
a central control device (20) is provided for controlling all the light units (2, 2', 2") of a lighting device (7).

7. Lighting device according to one of the previous claims,
**characterised in that**
the intensity of the light emitted from the or all the second diodes (14, 14', 14") can be controlled in a variable way.

8. Lighting device according to one of the previous claims,
**characterised in that**
the first (12, 12') and the or all the second diodes (14, 14') of a light unit (2, 2') are poured into a transparent mass forming the optics (13, 13').

9. Lighting device according to one of claims 1 to 5,
**characterised in that**
the optics (13") of a light unit (2") are a separate element at a distance from the diodes (12", 14").

## Revendications

1. Dispositif d'éclairage (1) en particulier pour un véhicule automobile, comprenant plusieurs unités d'éclairage (2, 2', 2") comprenant respectivement au moins une diode électroluminescente (DEL) (12, 12', 12") ainsi qu'un optique (13, 13', 13") associé à la diode et focalisant la lumière émise, dans le foyer duquel la diode (12, 12', 12") est disposée,
**caractérisé en ce**
**qu'**au moins une partie des unités d'éclairage (2, 2', 2") présente au moins une seconde diode électroluminescente (14, 14', 14"), qui est disposée en dehors du foyer de l'optique commun (13, 13', 13"), à l'occasion de quoi la première diode (12, 12', 12") et la ou toutes les secondes diodes (14, 14', 14") sont excitables de manière séparée.

2. Dispositif d'éclairage conformément à la revendication 1,
**caractérisé en ce**
**qu'**une unité d'éclairage (2, 2', 2") présente plusieurs secondes diodes (14, 14', 14") réparties et disposées en dehors du foyer de l'optique commun (13, 13', 13").

3. Dispositif d'éclairage conformément à la revendication 1 ou 2,
**caractérisé en ce**
**que** la ou toutes les secondes diodes (14, 14") et la première diode (12, 12") sont essentiellement disposées dans le même plan.

4. Dispositif d'éclairage conformément à la revendication 1 ou 2,
**caractérisé en ce**
**que** la ou toutes les secondes diodes (14') et la première diode (12') sont disposées sur différents plans par rapport à la direction d'émission de lumière.

5. Dispositif d'éclairage conformément à l'une des revendications précédentes,
**caractérisé en ce**
**que**, en cas de plusieurs secondes diodes (14, 14', 14"), chaque diode est excitable individuellement, ou en ce que les diodes sont excitables par groupes.

6. Dispositif d'éclairage conformément à l'une des revendications précédentes,
**caractérisé en ce**
**qu'**il est prévu un dispositif de commande central (20) pour la commande de toutes les unités d'éclairage (2, 2', 2") d'un dispositif d'éclairage (7).

7. Dispositif d'éclairage conformément à l'une des revendications précédentes,
**caractérisé en ce**
**que** l'intensité de la lumière émise de la ou de toutes les secondes diodes (14, 14', 14") peut être commandée de manière variable.

8. Dispositif d'éclairage conformément à l'une des revendications précédentes,
**caractérisé en ce**
**que** la première diode (12, 12') et la ou toutes les secondes diodes (14, 14') d'une unité d'éclairage (2, 2') sont coulées dans une masse transparente formant l'optique (13, 13').

9. Dispositif d'éclairage conformément à l'une des revendications 1 à 5,
**caractérisé en ce**
**que** l'optique (13") d'une unité d'éclairage (2") est un élément séparé, à distance des diodes (12", 14").
